# EUROPÄISCHE PATENTSCHRIFT

(11) **EP 2 457 270 B1**
(45) Veröffentlichungstag und Bekanntmachung des Hinweises auf die Patenterteilung: **09.07.2014**
(21) Anmeldenummer: 10737034.8
(22) Anmeldetag: 23.07.2010
(51) Int. Cl.: H01L 35/08, H01L 35/32, H01L 35/04, H01L 35/06

(54) **THERMOELEKTRISCHES MODUL**
THERMOELECTRIC MODULE
MODULE THERMOÉLECTRIQUE

(30) Priorität: 24.07.2009 EP 09166365
(43) Veröffentlichungstag der Anmeldung: 30.05.2012
(73) Patentinhaber: BASF SE, 67056 Ludwigshafen (DE)
(72) Erfinder: HAASS, Frank, 64390 Erzhausen (DE); STEFAN, Madalina Andreea, 67063 Ludwigshafen (DE); DEGEN, Georg, 64653 Lorsch (DE)
(86) Internationale Anmeldenummer: PCT/EP2010/060690
(87) Internationale Veröffentlichungsnummer: WO 2011/009935

(56) Entgegenhaltungen:
- EP-A2- 0 117 743
- DE-A1- 1 476 991
- DE-B- 1 040 054
- DE-B- 1 272 408
- GB-A- 874 660
- GB-A- 2 119 170
- JP-A- 10 321 920
- JP-A- 11 068 175
- JP-A- 2007 073 889
- JP-A- 2008 288 535
- JP-A- 2009 043 752
- US-A- 3 240 628
- US-B1- 6 274 803
- KRUTHA, J.-P.; LEVY, G.; KLOCKE, F.; CHILDS, T.H.C.: "Consolidation phenomena in laser and powder-bed based layered manufacturing", CIRP ANNALS - MANUFACTURING TECHNOLOGY, Bd. 56, Nr. 2, 2007, Seiten 730-759, XP002612141, DOI: 10.1016/j.cirp.2007.10.004 in der Anmeldung erwähnt

## Beschreibung

Die Erfindung betrifft thermoelektrische Module, die geeignet zum Aufbringen auf nicht-ebene, feste Wärmeträgeroberflächen sind.

Thermoelektrische Generatoren und Peltier-Anordnungen als solche sind seit langem bekannt. p- und n-dotierte Halbleiter, die auf einer Seite erhitzt und auf der anderen Seite gekühlt werden, transportieren elektrische Ladungen durch einen äußeren Stromkreis, wobei an einem Verbraucher im Stromkreis elektrische Arbeit verrichtet werden kann. Der dabei erzielte Wirkungsgrad der Konversion von Wärme in elektrische Energie wird thermodynamisch durch den Carnot-Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Bis heute werden jedoch nur Wirkungsgrade bis 6 % erzielt.

Legt man andererseits einen Gleichstrom an eine derartige Anordnung an, so wird Wärme von einer Seite zur anderen Seite transportiert. Eine derartige Peltier-Anordnung arbeitet als Wärmepumpe und eignet sich deshalb zur Kühlung von Apparateteilen, Fahrzeugen oder Gebäuden. Auch die Heizung über das Peltier-Prinzip ist günstiger als eine herkömmliche Heizung, weil immer mehr Wärme transportiert wird als dem zugeführten Energieäquivalent entspricht.

Gegenwärtig werden thermoelektrische Generatoren in Raumsonden zur Erzeugung von Gleichströmen, für den kathodischen Korrosionsschutz von Pipelines, zur Energieversorgung von Leucht- und Funkbojen, zum Betrieb von Radios und Fernsehapparaten eingesetzt. Die Vorteile der thermoelektrischen Generatoren liegen in ihrer äußersten Zuverlässigkeit. So arbeiten sie unabhängig von atmosphärischen Bedingungen wie Luftfeuchte; es erfolgt kein störungsanfälliger Stofftransport, sondern nur ein Ladungstransport; der Betriebsstoff wird kontinuierlich - auch katalytisch ohne freie Flamme - verbrannt, wodurch nur geringe Mengen an CO, NOₓ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit passt sich die thermoelektrische Energiewandlung äußerst flexibel in künftige Bedürfnisse wie Wasserstoffwirtschaft oder Energieerzeugung aus regenerativen Energien ein.

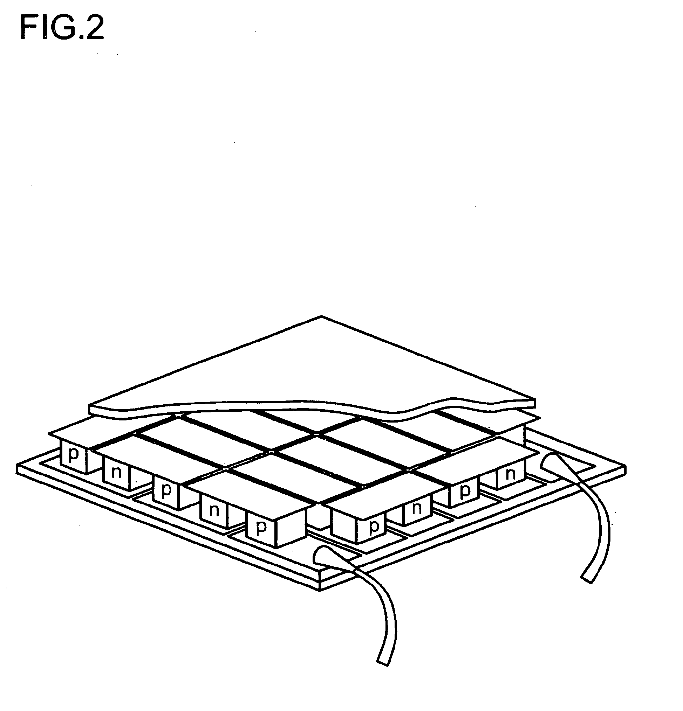

Ein thermoelektrisches Modul besteht aus p- und n-Schenkeln, die elektrisch in Reihe und thermisch parallel geschaltet sind. Figur 2 zeigt ein solches Modul.

Der klassische Aufbau besteht aus zwei Keramikplatten, zwischen denen die einzelnen Schenkel alternierend aufgebracht sind. Jeweils zwei Schenkel sind dabei elektrisch leitend über die Stirnflächen kontaktiert.

Neben der elektrisch leitfähigen Kontaktierung sind auf dem eigentlichen Material normalerweise noch verschiedene weitere Schichten aufgebracht, die als Schutzschichten oder als Lotschichten dienen. Letztlich wird der elektrische Kontakt zwischen zwei Schenkeln jedoch über eine Metallbrücke hergestellt.

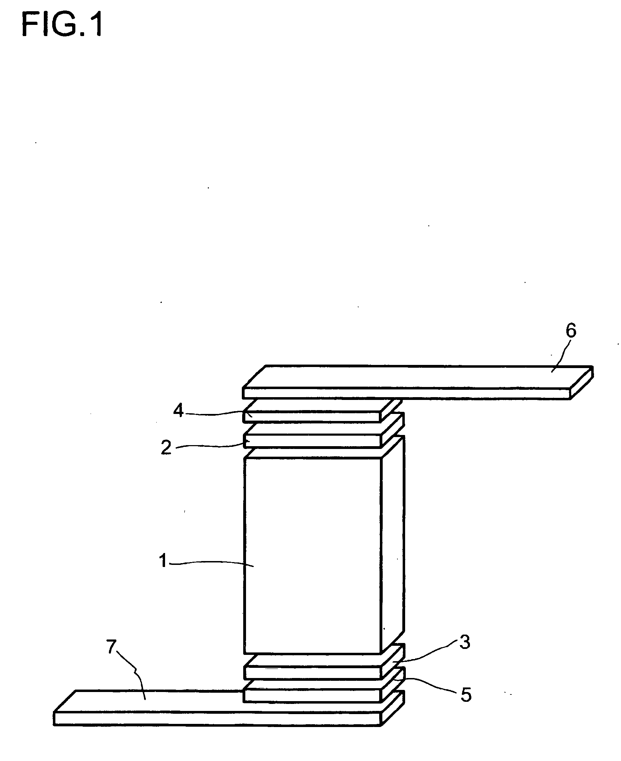

Ein wesentliches Element thermoelektrischer Bauteile ist die Kontaktierung. Die Kontaktierung stellt die physikalische Verbindung zwischen dem Material im "Herzen" des Bauteils (das für den gewünschten thermoelektrischen Effekt des Bauteils verantwortlich ist) und der "Außenwelt" her. Der Aufbau eines solchen Kontaktes ist in Fig. 1 schematisch dargestellt.

Das thermoelektrische Material **1** innerhalb des Bauteils sorgt für den eigentlichen Effekt des Bauteils. Dies ist ein thermoelektrischer Schenkel. Das Material 1 ist von einem elektrischen Strom und einem Wärmestrom durchflossen, um seinen Zweck in dem Gesamtaufbau zu erfüllen.

Das Material **1** ist an zumindest zwei Seiten über die Kontakte **4** und **5** mit den Zuleitungen **6** bzw. **7** verbunden. Die Schichten **2** und **3** sollen dabei eine oder mehrere gegebenenfalls notwendige Zwischenschichten (Barrierematerial, Lot, Haftvermittler o.ä.) zwischen dem Material **1** und den Kontakten **4** und **5** symbolisieren. Die jeweils paarweise zueinander gehörenden Segmente **2/3, 4/5, 6/7** können, müssen aber nicht identisch sein. Dies hängt letztlich ebenfalls vom spezifischen Aufbau und der Anwendung ab, ebenso wie auch die Flussrichtung von elektrischem Strom bzw. Wärmestrom durch den Aufbau.

Eine wichtige Rolle kommt nun den Kontakten **4** und **5** zu. Diese besorgen eine enge Verbindung zwischen Material und Zuleitung. Sind die Kontakte schlecht, so treten hier hohe Verluste auf, die die Leistung des Bauteils stark einschränken können. Aus diesem Grund werden die Schenkel und Kontakte in der Anwendung häufig auch auf das Material aufgepresst. Die Kontakte sind also einer starken mechanischen Belastung ausgesetzt. Diese mechanische Belastung nimmt noch zu, sobald erhöhte (oder auch erniedrigte) Temperaturen oder/und thermische Wechsel eine Rolle spielen. Die thermische Ausdehnung der im Bauteil verbauten Materialien führt unweigerlich zu mechanischen Spannungen, die im Extremfall durch einen Abriss des Kontaktes zu einem Versagen des Bauteils führen.

Um dem vorzubeugen, müssen die verwendeten Kontakte eine gewisse Flexibilität und Federeigenschaften aufweisen, damit solche thermischen Spannungen ausgeglichen werden können.

Um dem ganzen Gefüge Stabilität zu verleihen und die notwendige, möglichst homogene Wärmeankoppelung über die Gesamtzahl der Schenkel zu gewährleisten, sind Trägerplatten notwendig. Hierzu wird üblicherweise eine Keramik genutzt, beispielsweise aus Oxiden oder Nitriden wie Al₂O₃, SiO₂ oder AIN.

Dieser typische Aufbau bringt eine Reihe von Nachteilen mit sich. Die Keramik sowie die Kontakte sind nur begrenzt mechanisch belastbar. Mechanische und/oder thermische Spannungen können leicht zu Rissen oder einem Abriss der Kontaktierung führen, die das gesamte Modul unbrauchbar machen.

Weiterhin sind dem klassischen Aufbau auch im Hinblick auf eine Anwendung Grenzen gesetzt, da stets nur planare Flächen mit dem thermoelektrischen Modul in Verbindung gebracht werden können. Eine enge Verbindung zwischen der Moduloberfläche und der Wärmequelle/Wärmesenke ist unerlässlich, um für einen ausreichenden Wärmefluss zu sorgen.

Nicht planare Oberflächen, wie beispielsweise ein rundes Abwärmerohr, sind einem direkten Kontakt mit dem klassischen Modul nicht zugänglich oder erfordern einen entsprechenden begradigten Wärmetauscheraufbau, um einen Übergang von der nichtplanaren Oberfläche zum planaren Modul zu schaffen.

Die Kontaktierung in den thermoelektrischen Modulen ist in der Regel starr. In Mat. Res. Soc. Symp. Proc. Vol. 234, 1991, Seiten 167 bis 177, sind Bleitellurid-Anwendungskonzepte beschrieben. In Figur 1 ist eine Kontaktierung gezeigt, in der auf der kalten Seite des thermoelektrischen Moduls der Kontakt eine U-förmige Ausbuchtung zeigt. Auf der warmen Seite des Moduls erfolgt eine Kontaktierung durch starre Kontakte. Auch diese Art der Kontaktierung erlaubt keinen Einsatz auf nicht-planaren Oberflächen.

JP-A-2009 043752 betrifft ein thermoelektrisches Modul. Wie in Figur 2a und 2b dargestellt, kann die Kontaktierung zwischen zwei thermoelektrischen Materialien über eine gebogene Kontaktierung erfolgen.

JP-A-10 321929 betrifft einen thermoelektrischen Transducer. Die Kontaktierung zwischen zwei thermoelektrischen Materialien weist eine S-förmige Struktur auf, die zudem noch federartig gebogen sein kann, siehe die Figuren 4, 5 und 10.

CIRP Annals-Manufacturing Technology, Bd. 56, No. 2, 2007, Seiten 730 bis 759 (D3) beschreibt Laser- und Pulver-basiertes Layered Manufacturing. Dabei werden unterschiedliche Verfahren vorgestellt, mit denen Metallstrukturen ausgebildet werden können. Auf den Bezug zu thermoelektrischen Modulen gibt es keinen Hinweis.

DE-B-10 40 054 betrifft eine thermoelektrische Kühleinrichtung. Der thermoelektrische Generator kann in ein Matrixmaterial eingebettet sein.

US 6,274,803 betrifft ein thermoelektrisches Modul mit verbesserter Wärmetransfereffizienz. Dabei werden die Zwischenräume zwischen thermoelektrischen Materialschenkeln mit einem Harz ausgefüllt.

Aufgabe der vorliegenden Erfindung ist die Bereitstellung von thermoelektrischen Modulen, die flexibel an nicht-planare Wärmeträgeroberflächen angepasst werden können und flexibel auf eine thermische und mechanische Belastung reagieren.

Die Aufgabe wird erfindungsgemäß gelöst durch ein thermoelektrisches Modul aus p- und n-leitenden thermoelektrischen Materialschenkeln, die wechselseitig über elektrisch leitfähige Kontakte miteinander verbunden sind, wobei die elektrisch leitfähigen Kontakte auf der kalten und der warmen Seite des thermoelektrischen Moduls zwischen den thermoelektrischen Materialschenkeln in ihrem Verlauf mindestens eine Flexibilitätsstelle aufweisen, die ein Verbiegen und geringfügiges Verschieben der thermoelektrischen Materialschenkel gegeneinander erlaubt. Dabei sind die elektrisch leitfähigen Kontakte aus mindestens einem duktilen Metall geschichtet verbunden mit mindestens einem härteren Metall, hergestellt. Das duktile Metall weist eine geringere Härte als das härtere Metall auf. Beispiele für duktile Metalle sind Kupfer und Aluminium. Beispiele für härtere Metalle sind Eisen, Stahl oder Nickel. Wenn das duktilere Metall und das härtere Metall oder Material geschichtet werden, so wird eine Flexibilitätsstelle in der Elektrode geschaffen. Vorzugsweise ist dabei die Schicht des duktilen Metalls dicker als die Schicht des weniger duktilen Materials.

Der Ausdruck "Flexibilitätsstelle" beschreibt eine Stelle im Verlauf des elektrischen Kontakts, die ein Verbiegen oder ein Verschieben des mit dem p-Schenkel und n-Schenkel verbundenen Kontakts erlaubt. Die beiden Materialschenkel sollen geringfügig gegeneinander verschiebbar sein. Der Begriff "geringfügig" beschreibt dabei eine Verschiebung um maximal 20 %, besonders bevorzugt maximal 10 % des Abstandes zwischen den jeweiligen p- und n-leitenden, thermoelektrischen Materialschenkeln. Die Möglichkeit des Verbiegens stellt sicher, dass die Kontaktierung von keinem der Materialschenkel abreißt, wenn das thermoelektrische Modul an eine nicht-ebene Oberfläche angepasst wird.

Das Verbiegen soll vorzugsweise um einen Winkel von maximal 45°, besonders bevorzugt maximal 20°, möglich sein, ohne dass die Kontaktierung der thermoelektrischen Materialschenkel abreißt.

Die Flexibilitätsstelle kann jede beliebige geeignete Form aufweisen, sofern die vorstehend beschriebene Funktion erfüllt wird. Vorzugsweise liegt die Flexibilitätsstelle in Form mindestens einer U-förmigen, V-förmigen oder rechteckigen Ausbuchtung des jeweiligen Kontaktes vor. Besonders bevorzugt liegt dabei eine U-förmige, V-förmige oder rechteckige Ausbuchtung des jeweiligen Kontaktes vor.

Alternativ kann die Flexibilitätsstelle vorzugsweise in Form einer Welle, Spirale oder in Sägezahnform des jeweiligen Kontaktes vorliegen.

Das erfindungsgemäße thermoelektrische Modul ist insbesondere dann vorteilhaft, wenn die thermoelektrischen Materialschenkel nicht planar angeordnet sind. Dies bedeutet, dass die thermoelektrischen Materialschenkel nicht parallel zu einer Ebene angeordnet sind.

Die erfindungsgemäße Auslegung der thermoelektrischen Materialschenkel erlaubt das spiralförmige Aufwickeln des thermoelektrischen Moduls auf ein Rohr beliebigen Querschnitts. Dabei kann es sich um rechteckige, runde, ovale oder andere Querschnitte handeln.

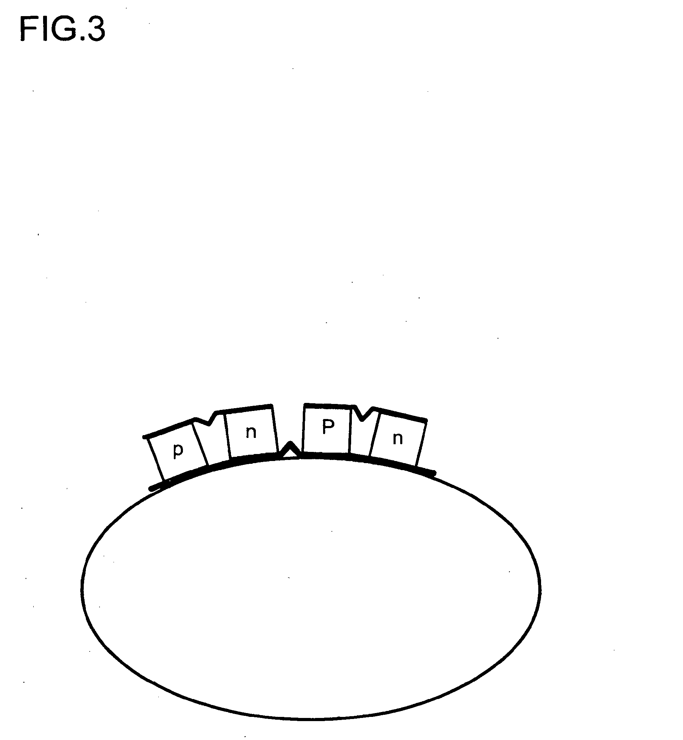

Figur 3 zeigt in einer Prinzipskizze, wie das thermoelektrische Modul um ein ovales Wärmeträgerrohr gewickelt werden kann.

Damit ist erfindungsgemäß die Anpassung des thermoelektrischen Moduls an beliebige dreidimensionale Oberflächen des Wärmetauschmaterials möglich. Auch nicht-planare Wärmequellen oder Wärmesenken sind auf diese Weise einer engen Verbindung mit dem thermoelektrischen Modul zugänglich.

Typischerweise werden durch ein Rohr Abwärme oder Kühlmittel geleitet. Besonders bevorzugt handelt es sich um ein Autoabgasrohr.

Die erfindungsgemäße Auslegung der Biegsamkeit und Verschiebbarkeit der Kontakte erlaubt es, thermische und mechanische Spannungen besser auszugleichen und abzubauen.

Durch die Wickelbarkeit der thermoelektrischen Module kann man einen Strang von wechselnden p- und n-Schenkeln ohne Abriss der Kontakte um ein rundes oder ovales Rohr wickeln. Dies ermöglicht eine kostengünstige, schnelle und einfache Integration thermoelektrischer Bauteile beispielsweise in den Abgasstrang eines Automobils, in, um, an, vor oder nach einem Kfz-Katalysator, in einer Heizungseinrichtung, usw.

Die elektrisch leitfähigen Kontakte können aus beliebigen geeigneten Materialien aufgebaut sein. Typischerweise sind sie aus Metallen oder Metalllegierungen, beispielsweise Eisen, Nickel, Aluminium, Platin oder anderen Metallen aufgebaut. Es ist auf eine ausreichende Temperaturbeständigkeit der Metallkontaktierung zu achten, da die thermoelektrischen Module häufig hohen Temperaturen ausgesetzt sind.

Gemäß einer Ausführungsform der Erfindung werden die elektrisch leitfähigen Kontakte durch Layered Manufacturing oder Metal Injection Molding (MIM) hergestellt.

Dabei ist das Layered Manufacturing vorzugsweise ein Selective Laser Sintering (SLS) oder Selective Laser Melting (SLM).

Geeignete Layered Manufacturing (LM)-Verfahren sind in Annals of the CIRP Vol. 56/2/2007, Seiten 730 bis 759, beschrieben. Die Herstellung erfolgt dabei vorzugsweise durch Rapid Manufacturing (RM) bzw. Rapid Prototyping (RP). Unter den Layered Manufacturing (LM)-Techniken gehören beispielsweise die Photopolymerisation (Stereolithographie SLA), das Ink-Jet-Printing (IJP), das 3D-Printing (3DP), das Fused Deposition Modelling (FDM), das Selective Laser Sintering (SLS) und Selective Laser Melting (SLM), wie auch das Selective Electron Beam Melting (EBM). Auch das Laminated Object Manufacturing (LOM), das Laser Cladding (LC), können eingesetzt werden. Diese Verfahren sind beispielhaft in der vorgenannten Literaturstelle beschrieben.

Eine weitere Erhöhung der mechanischen Festigkeit kann dadurch erfolgen, dass die thermoelektrischen Materialschenkel in ein festes, nicht elektrisch leitendes Matrixmaterial eingebettet sind.

Um das thermoelektrische Material stabil in einer umwickelten Form zu halten, ist es empfehlenswert, eine Matrix oder ein Gitter zur Stabilisierung des thermoelektrischen Moduls einzusetzen. Hierzu werden bevorzugt Materialien mit niedriger Wärmeleitfähigkeit und fehlender elektrischer Leitfähigkeit eingesetzt. Beispiele geeigneter Materialien sind Aerogele, Keramiken, besonders aufgeschäumte Keramiken, Glaswolle, Glaskeramik-Mischungen, elektrisch isolierte Metallgitter, Glimmer oder eine Kombination dieser Materialien. Für den Temperaturbereich bis 400°C können auch synthetische Polymere auf Kohlenstoffbasis wie Polyurethane, Polystyrol, Polycarbonat, Polypropylen oder natürlich vorkommende Polymere wie Kautschuk verwendet werden. Die Matrixmaterialien können als Pulver, als Formkörper, als Suspension, als Paste, als Schaum oder als Glas eingesetzt werden. Durch eine Temperung oder Bestrahlung kann die Matrix ausgehärtet werden, wie auch durch Verdampfen der Lösungsmittel oder durch Vernetzung der eingesetzten Materialien. Die Matrix kann schon vor dem Einsatz durch Formgebung an die entsprechende Anwendung angepasst oder bei der Anwendung gegossen, gespritzt, gesprüht, gerakelt oder aufgetragen werden.

Die elektrischen Kontakte können in beliebiger Weise mit den thermoelektrischen Materialschenkeln verbunden sein. Sie können beispielsweise vorab auf die Schenkel aufgebracht werden, beispielsweise durch Auflegen, Aufpressen, Auflöten, Aufschweißen vor dem Einbau in ein thermoelektrisches Modul, und sie können auch auf das elektrisch isolierende Substrat aufgebracht werden. Zudem ist es möglich, sie in einem Einschritt-Verfahren zusammen mit den elektrisch isolierten Substraten und den thermoelektrischen Schenkeln zu verpressen, zusammenzulöten oder zu schweißen.

Die thermoelektrischen Module können in beliebiger geeigneter Weise mit dem Wärmeträgermedium kontaktiert werden. Eine Wicklung des thermoelektrischen Moduls kann beispielsweise extern, d. h. um ein Rohr herum, als auch intern, d. h. auf einem im Rohr angebrachten Innenträger erfolgen. Der Innenträger kann eine elektrisch isolierende Beschichtung oder Schicht auf der Innenwand des Rohres sein. Durch das Anbringen am Innenträger kann das thermoelektrische Material/Schenkel direkt mit dem Wärmeträgermedium kontaktiert werden.

Typischerweise werden entweder Wärmeträgermedien zu Kühlzwecken kontaktiert, oder erwärmte Abgase aus Heizungsanlagen oder von Verbrennungsmotoren. Es ist aber auch möglich, die thermoelektrischen Module für die Abwärmenutzung auf die nicht-verspiegelte Seite der Parabolrinnen in der Photovoltaik, an Schmelzkesselwände oder Reaktorwände zu setzen.

Die Erfindung betrifft entsprechend auch die Verwendung der thermoelektrischen Module zum Aufbringen auf nicht-ebene, feste Wärmeträgeroberflächen und Abgasleitungen mit darauf spiralförmig aufgewickelten thermoelektrischen Modulen, wie sie vorstehend beschrieben sind.

Die erfindungsgemäßen Halbleitermaterialien können auch nach Methoden zu thermoelektrischen Generatoren oder Peltier-Anordnungen zusammengefügt werden, welche dem Fachmann an sich bekannt sind und beispielsweise in WO 98/44562, US 5,448,109, EP-A- 1 102 334 oder US 5,439,528 beschrieben sind.

Die erfindungsgemäßen thermoelektrischen Generatoren oder Peltier-Anordnungen erweitern im Allgemeinen die vorhandene Bandbreite an thermoelektrischen Generatoren und Peltier-Anordnungen. Durch Variation der chemischen Zusammensetzung der thermoelektrischen Generatoren oder Peltier-Anordnungen ist es möglich, unterschiedliche Systeme bereitzustellen, welche unterschiedlichen Anforderungen in einer Vielzahl an Anwendungsmöglichkeiten gerecht werden. Beispielsweise können unterschiedliche thermoelektrische Materialien spiralförmig um z. B. Rohre gewickelt werden, die unterschiedliche Temperaturbereiche aufweisen. ZT-Werte können an diese Temperaturen angepasst werden.

Die vorliegende Erfindung betrifft auch die Verwendung eines erfindungsgemäßen thermoelektrischen Generators oder einer erfindungsgemäßen Peltier-Anordnung.
- als Wärmepumpe
- zur Klimatisierung von Sitzmöbeln, Fahrzeugen und Gebäuden
- in Kühlschränken und (Wäsche)trocknern
- zur simultanen Heizung und Kühlung von Stoffströmen bei Verfahren der Stofftrennung wie
   - Absorption
   - Trocknung
   - Kristallisation
   - Verdampfung
   - Destillation
- als Generator zur Nutzung von Wärmequellen wie
   - solarer Energie
   - Erdwärme
   - Verbrennungswärme fossiler Brennstoffe
   - von Abwärmequellen in Fahrzeugen und stationären Anlagen
   - von Wärmesenken beim Verdampfen flüssiger Stoffe
   - biologischer Wärmequellen
- zur Kühlung elektronischer Bauteile

Des Weiteren betrifft die vorliegende Erfindung eine Wärmepumpe, einen Kühlschrank, einen (Wäsche)trockner oder einen Generator zur Nutzung von Wärmequellen, enthaltend mindestens einen erfindungsgemäßen thermoelektrischen Generator oder eine erfindungsgemäße Peltier-Anordnung, über den oder die beim (Wäsche)trockner ein zu trocknendes Material direkt oder indirekt aufgeheizt und über den oder die der bei der Trocknung anfallende Wasser- oder Lösungsmitteldampf direkt oder indirekt abgekühlt wird.

Die Erfindung wird durch die nachstehenden Beispiele näher erläutert.

### Beispiele

### Beispiel 1

In eine vorgefertigte Matrix (Leg-Halterung) wurden die n- und p-Schenkel aus PbTe-Material eingefügt. Fe-Legierungselektroden mit einer Dicke von etwa 1,5 mm wurden nach dem Rapid-Prototyping-Verfahren hergestellt. Die Elektroden wurden geschweißt, wobei sich verbesserte Kontakte durch kleine Mengen an PbTe-Pulver zwischen den Elektroden und den thermoelektrischen Schenkeln ergaben. Die Kontaktwiderstände lagen im allgemeinen unter den Kontaktwiderständen der Kontakte mit flachen Elektroden.

### Beispiel 2

n- und p-Schenkel aus PbTe-Material wurden über Heißpressen mit Elektroden kontaktiert, die durch MIM aus einer Fe-Legierung hergestellt wurden und eine Dicke von etwa 2 mm aufwiesen.

Die kontaktierten Schenkel wurden anschließend in eine Metallkapsel, die innen elektrisch isoliert war, eingeschlossen.

## Patentansprüche

1. Thermoelektrisches Modul aus p- und n-leitenden thermoelektrischen Materialschenkeln, die wechselseitig über elektrisch leitfähige Kontakte (4,5) miteinander vierbunden sind, wobei die elektrisch leitfähigen Kontakte (4,5) auf der kalten und der warmen Seite des thermoelektrischen Moduls zwischen den thermoelektrischen Materialschenkeln (1) in ihrem Verlauf mindestens eine Flexibilitätsstelle aufweisen, die ein Verbiegen und geringfügiges Verschieben der thermoelektrischen Materialschenkel (1) gegeneinander erlaubt, **dadurch gekennzeichnet, dass** die elektrisch leitfähigen Kontakte (4,5) aus mindestens einem duktilen Metall, geschichtet verbunden mit mindestens einem härteren Metalle, hergestellt sind.

2. Thermoelektrisches Modul nach Anspruch 1, **dadurch gekennzeichnet, dass** die Flexibilitätsstelle in Form mindestens einer U-förmigen, V-förmigen oder rechteckigen Ausbuchtung des jeweiligen Kontaktes vorliegt.

3. Thermoelektrisches Modul nach Anspruch 1, **dadurch gekennzeichnet, dass** die Flexibilitätsstelle in Form einer Welle, Spirale oder in Sägezahnform des jeweiligen Kontaktes Vorliegt.

4. Thermoelektrisches Modul nach einem der Ansprüche 1 bis 3, **dadurch gekennzeichnet, dass** die elektrisch leitfähigen Kontakte (4,5) durch Layered Manufacturing oder Metal Injection Molding (MIM) hergestellt werden.

5. Thermoelektrisches Modul nach Anspruch 4, **dadurch gekennzeichnet, dass** das Layered Manufacturing ein Selective Laser Sintering (SLS) oder Selective Laser Melting (SLM) ist.

6. Thermoelektrisches Modul nach einem der Ansprüche 1 bis 5, **dadurch gekennzeichnet, dass** die thermoelektrischen Materialschenkel (1) nicht planar angeordnet sind.

7. Thermoelektrisches Modul nach Anspruch 6, **dadurch gekennzeichnet, dass** die thermoelektrischen Materialschenkel (1) spiralförmig auf ein Rohr beliebigen Quer-/ schnitts aufgewickelt sind.

8. Thermoelektrisches Modul nach Anspruch 7, **dadurch gekennzeichnet, dass** durch das Rohr Abwärme oder Kühlmittel geleitet werden.

9. Thermoelektrisches Modul nach Anspruch 8, **dadurch gekennzeichnet, dass** durch das Rohr Autoabgase geleitet werden.

10. Thermoelektrisches Modul nach einem der Ansprüche 1 bis 9, **dadurch gekennzeichnet, dass** die thermoelektrischen Materialschenkel (1) in ein festes, nicht elektrisch leitendes Matrixmaterial eingebettet sind.

11. Verwendung thermoelektrischer Module nach einem der Ansprüche 1 bis 10 zum Aufbringen auf nicht-ebene, feste Wärmeträgeroberflächen.

12. Autoabgasleitung mit darauf spiralförmig aufgewickeltem thermoelektrischem Modul nach einem der Ansprüche 1 bis 10.

13. Wärmepumpe, Kühlschrank, Trockner oder Generator, mit auf eine Wärmeträgerleitung spiralförmig aufgewickeltem thermoelektrischem Modul nach einem der Ansprüche 1 bis 10.

## Claims

1. A thermoelectric module composed of p- and n-conducting thermoelectric material legs which are mutually connected to one another via electrically conductive contacts (4, 5), the electrically conductive contacts (4, 5) having on the cold and hot sides of the thermoelectric module between the thermoelectric material legs (1) in their course at least one flexibility location which permits flexure and slight displacement of the thermoelectric material legs (1) relative to one another, wherein the electrically conductive contacts (4, 5) are produced from at least one ductile metal, bonded in a layered fashion with at least one harder metal.

2. The thermoelectric module according to claim 1, wherein the flexibility location is present in the form of at least one U-shaped, V-shaped or rectangular protuberance of the respective contact.

3. The thermoelectric module according to claim 1, wherein the flexibility location is present in the form of an undulation, spiral or in sawtooth form of the respective contact.

4. The thermoelectric module according to any of claims 1 to 3, wherein the electrically conductive contacts (4, 5) are produced by layered manufacturing or metal injection molding (MIM).

5. The thermoelectric module according to claim 4, wherein the layered manufacturing is selective laser sintering (SLS) or selective laser melting (SLM).

6. The thermoelectric module according to any of claims 1 to 5, wherein the thermoelectric material legs (1) are arranged in non-planar fashion.

7. The thermoelectric module according to claim 6, wherein the thermoelectric material legs (1) are wound spirally onto a pipe of any desired cross section.

8. The thermoelectric module according to claim 7, wherein waste heat or coolants are conducted through the pipe.

9. The thermoelectric module according to claim 8, wherein automobile exhaust gases are conducted through the pipe.

10. The thermoelectric module according to any of claims 1 to 9, wherein the thermoelectric material legs (1) are embedded into a solid matrix material that is not electrically conductive.

11. The use of thermoelectric modules according to any of claims 1 to 10 for application to non-planar, solid heat transfer medium surfaces.

12. An automobile exhaust gas line comprising the thermoelectric module according to any of claims 1 to 10 wound spirally thereon.

13. A heat pump, refrigerator, drier or generator, comprising the thermoelectric module according to any of claims 1 to 10 wound spirally onto a heat transfer medium line.

## Revendications

1. Module thermoélectrique constitué de branches de matériau thermoélectrique à conduction p et à conduction n reliées les unes aux autres en alternance par des contacts électriquement conducteurs (4, 5),
les contacts électriquement conducteurs (4, 5) présentant sur le côté froid et le côté chaud de la partie du module thermoélectrique située entre les branches (1) de matériau thermoélectrique au moins un emplacement flexible qui permet une flexion et un léger déplacement des branches (1) de matériau thermoélectrique,
**caractérisé en ce que**
les contacts électriquement conducteurs (4, 5) sont réalisés en au moins un métal ductile relié par enduction à au moins un métal plus dur.

2. Module thermoélectrique selon la revendication 1, **caractérisé en ce que** l'emplacement flexible présente la forme d'au moins une découpe du contact concerné en forme de U, en forme de V ou rectangulaire.

3. Module thermoélectrique selon la revendication 1, **caractérisé en ce que** l'emplacement flexible présente la forme d'une ondulation, d'une spirale ou de dents de scie du contact concerné.

4. Module thermoélectrique selon l'une des revendications 1 à 3, **caractérisé en ce que** les contacts électriquement conducteurs (4, 5) sont réalisés par fabrication stratifiée ou moulage de métal par injection ("Metal Injection Molding" - MIM).

5. Module thermoélectrique selon la revendication 4, **caractérisé en ce que** la fabrication par stratification s'effectue par frittage sélectif au laser ("Selective Laser Sintering" - SLS) ou par fusion sélective au laser ("Selective Laser Melting" - SLM).

6. Module thermoélectrique selon l'une des revendications 1 à 5, **caractérisé en ce que** les branches (1) en matériau thermoélectrique ne sont pas disposées dans un plan.

7. Module thermoélectrique selon la revendication 6, **caractérisé en ce que** les branches (1) de matériau thermoélectrique sont enroulées en spirale sur un tube de section transversale quelconque.

8. Module thermoélectrique selon la revendication 7, **caractérisé en ce que** la chaleur dégagée ou un fluide de refroidissement sont guidés dans le tube.

9. Module thermoélectrique selon la revendication 8, **caractérisé en ce que** des gaz d'échappement de voiture sont guidés dans le tube.

10. Module thermoélectrique selon l'une des revendications 1 à 9, **caractérisé en ce que** les branches (1) de matériau thermoélectrique sont incorporées dans un matériau de matrice solide et électriquement non conducteur.

11. Utilisation de modules thermoélectriques selon l'une des revendications 1 à 10 pour l'application sur des surfaces caloporteuses solides non planes.

12. Conduit de gaz d'échappement de voiture sur lequel un module thermoélectrique selon l'une des revendications 1 à 10 est enroulé en spirale.

13. Pompe à chaleur, armoire frigorifique, séchoir ou générateur dotés d'un module thermoélectrique selon l'une des revendications 1 à 10 enroulé en spirale sur un conduit caloporteur.
